# EUROPEAN PATENT APPLICATION

(11) **EP 3 623 822 A1**
(43) Date of publication of application: **18.03.2020**
(21) Application number: 19161112.8
(22) Date of filing: 06.03.2019
(51) Int. Cl.: G01R 15/14, G01R 15/20, G01R 1/20, H01M 10/48

(54) **REDUNDANT CURRENT SAMPLING ASSEMBLY**

(30) Priority: 17.09.2018 CN 201821518928 U
(71) Applicant: Contemporary Amperex Technology Co., Limited, Jiaocheng District Ningde City, Fujian 352100 (CN)
(72) Inventor: ZENG, Yuqun, Ningde City, Fujian 352100 (CN); WU, Kai, Ningde City, Fujian 352100 (CN); WU, Guoxiu, Ningde City, Fujian 352100 (CN); HU, Shushuai, Ningde City, Fujian 352100 (CN); LI, Qiandeng, Ningde City, Fujian 352100 (CN); YANHUI, Fu, Ningde City, Fujian 352100 (CN)
(74) Representative: Slingsby Partners LLP

(57) **Abstract**

The present disclosure relates to a sampling assembly and a battery pack. The sampling assembly is configured to acquire electrical parameters between two charged terminals to be detected (700), and the sampling assembly comprises: a circuit board (500), comprising a sampling unit (510) for receiving sampling signals; a first detector (100), comprising a first connecting end (110) and a second connecting end (120) arranged at interval, wherein the first detector (100) is connected to the circuit board (500) via the first connecting end (110) and the second connecting end (120) to transmit information on first voltage between the first connecting end (110) and the second connecting end (120) to the circuit board (500), and the first detector (100) is connectable in series to and between the two terminals to be detected (700), so that current flows through the first detector (100) and generates a magnetic field around the first detector (100); and a second detector (200), located in the magnetic field and can generate information on second voltage according to the magnetic field, wherein the second detector (200) comprises an output terminal (210), and the second detector (200) can be connected to the circuit board (500) via the output terminal (210) to transmit the information on second voltage to the sampling unit (510).

## Description

### TECHNICAL FIELD

The present disclosure relates to the technical field of power battery equipment, in particular to a sampling assembly and a battery pack.

### BACKGROUND

A battery management system is the brain of an electric vehicle, and restricts the development of the electric vehicle. The battery management system mainly ensures the driving safety and stability of the electric vehicle by collecting the voltage, temperature and current of a battery pack. Current is an important factor of the estimation accuracy of the state of charge, so the detection on the charge and discharge current of the battery pack is particularly important.

At present, most battery management systems use a single current collection method, so the reliability of the collected current is poor. Once it fails, the battery management system will lose current detection and monitoring, seriously affecting the safe and stable driving of the electric vehicle. Very few battery management system products use two redundant current sensors to collect the current of the battery pack in light of the functional safety, which requires connecting separate sampling assemblies to a module, but the two independent sampling assemblies are complicated in structure and troublesome to install and excessively occupy the limited space of the battery pack.

Therefore, a new sampling assembly and a new battery pack are urgently needed.

### SUMMARY

The embodiments of the present disclosure provide a sampling assembly and a battery pack, and aim to provide a sampling assembly with high reliability and simple structure.

An embodiment of the present disclosure, in an aspect, provides a sampling assembly for acquiring electrical parameters between two charged terminals to be detected, the sampling assembly comprising: a circuit board, comprising a sampling unit for receiving sampling signals; a first detector, comprising a first connecting end and a second connecting end arranged at interval, wherein the first detector is connected to the circuit board via the first connecting end and the second connecting end to transmit information on first voltage between the first connecting end and the second connecting end to the sampling unit, and the first detector is connectable in series to and between the two terminals to be detected, so that current flows through the first detector and generates a magnetic field around the first detector; and a second detector, which is located in the magnetic field and can generate information on second voltage according to the magnetic field, wherein the second detector comprises an output terminal, and the second detector can be connected to the circuit board via the output terminal to transmit the information on second voltage to the sampling unit.

According to one aspect of the present disclosure, the first detector and the second detector are arranged on two sides of the circuit board, and are correspondingly arranged in a thickness direction of the circuit board.

According to one aspect of the present disclosure, the sampling assembly further comprises a magnetic gathering sheet arranged around the second detector to gather the magnetic field.

According to one aspect of the present disclosure, the magnetic gathering sheet is of U-shape, has two opposite side walls and a bottom wall connecting the two side walls, and spans the two sides of the second detector and the first detector via the side walls.

According to one aspect of the present disclosure, the first detector is arranged between the bottom wall and the circuit board, or the second detector is arranged between the bottom wall and the circuit board.

According to one aspect of the present disclosure, the sampling assembly further comprises a fixing seat to fix the magnetic gathering sheet and the first detector to the circuit board.

According to one aspect of the present disclosure, the fixing seat comprises a first groove and a second groove distributed successively, the first groove matches the first detector in shape, and the second groove matches the magnetic gathering sheet in shape, so that the fixing seat can be sleeved on the magnetic gathering sheet and the first detector via the first groove and the second groove, and fixes the first detector and the magnetic gathering sheet to the circuit board.

According to one aspect of the present disclosure, the first detector further comprises a first input end and a first output end, so that the first detector is connectable in series to and between the two terminals to be detected via the first input end and the first output end.

According to one aspect of the present disclosure, the first input end is columnar and is axially provided with a threaded hole so that one terminal to be detected is connected to the first input end via the threaded hole, and the first detector is provided with a connecting hole so that the first input end is connected to the first detector via the connecting hole;
and/or, the first output end is columnar and is axially provided with a threaded hole so that one terminal to be detected is connected to the first output end via the threaded hole, and the first detector is provided with a connecting hole so that the first output end is connected to the first detector via the connecting hole.

According to one aspect of the present disclosure, the first detector has a top surface and a bottom surface opposite to each other, the first input end and the first output end are arranged on the top surface, and the first connecting end and the second connecting end are arranged on the bottom surface.

According to one aspect of the present disclosure, the sampling unit comprises a first sampling circuit and a second sampling circuit, the first detector is connected to the first sampling circuit via the first connecting end and the second connecting end, and the second detector is connected to the second sampling circuit via the output terminal.

A second embodiment of the present disclosure provides a battery pack, comprising: a case in which more than one battery module is arranged; two terminals to be detected; and said sampling assembly, wherein the first detector of the sampling assembly is connectable in series to and between the two terminals to be detected, and the circuit board of the sampling assembly is located inside or outside the case.

The sampling assembly according to the embodiment of the present disclosure comprises the first detector and the second detector, the first detector is connectable in series to and between the two charged terminals to be detected so that current flows through the first detector, the current flows between the first connecting end and the second connecting end so that there is a pressure difference between the first connecting end and the second connecting end, and the first connecting end and the second connecting end are connected to the circuit board and can transmit the information on first voltage to the sampling unit so as to achieve the purpose of detecting electrical parameters between the charged terminals to be detected. In addition, when the current flows through the first detector, a magnetic field is generated around the first detector, and the second detector can generate information on second voltage according to the magnetic field and transmit the information on second voltage to the sampling unit, so that electrical parameters between the two terminals to be detected are acquired according to the information on second voltage. Therefore, the embodiment of the present disclosure can separately acquire electrical parameters via the first detector and the second detector in different manners, thereby effectively avoiding the common cause failure and improving the reliability of the sampling assembly. Moreover, the first detector and the second detector according to the embodiment of the present disclosure are directly connected to the circuit board, which can reduce the transmission distance of the sampling information and enhance the anti-interference ability of signals.

### BRIEF DESCRIPTION OF THE DRAWINGS

Other features, objectives and advantages of the present disclosure will become more apparent by reading the following detailed descriptions of nonrestrictive embodiments made with reference to the accompanying drawings, wherein the same or similar reference signs indicate the same or similar features.
Fig. 1 is a structural view of a sampling assembly according to an embodiment of the present disclosure;
Fig. 2 is a partial structural view of a sampling assembly according to an embodiment of the present disclosure;
Fig. 3 is a side view of Fig. 2;
Fig. 4 is an exploded view of Fig. 2;
Fig. 5 is a structural view of a second detector of a sampling assembly according to an embodiment of the present disclosure;
Fig. 6 is a side view of Fig. 5;
Fig. 7 is a structural view of a battery pack according to an embodiment of the present disclosure.

### Reference signs:

100, first detector;
110, first connecting end; 120, second connecting end; 130, first input end; 140, first output end; 150, connecting hole; 160, third connecting end; 170, limiting post;
200, second detector;
210, output terminal;
300, magnetic gathering sheet;
310, side wall; 320, bottom wall;
400, fixing seat;
410, first groove; 420, second groove;
500, circuit board; 510, sampling unit;
600, case;
610, battery module;
700, terminal to be detected.

### DETAILED DESCRIPTION

Features and exemplary embodiments of various aspects of the present disclosure are described in detail below. In the following detailed descriptions, numerous specific details are proposed to provide a comprehensive understanding on the present disclosure. However, it will be apparent to those skilled in the art that the present disclosure may be practiced without some of these specific details. The following descriptions of the embodiments are merely to provide a better understanding on the present disclosure by showing the examples of the present disclosure. In the drawings and the following description, at least part of the known structures and techniques are not shown in order to avoid unnecessary obscuring of the present disclosure; and, for clarity, the dimensions of part of the structures may be exaggerated. Furthermore, the features, structures or characteristics described hereinafter may be combined in any suitable manner in one or more embodiments.

The orientations appearing in the following description are all directions shown in the drawings and are not intended to limit the specific structures of the embodiments of the present disclosure. In the description of the present disclosure, it should be noted that, unless otherwise specified and defined, the terms "mounted" and "connected" should be generally understood, for example, the "connected" may be fixedly connected, detachably connected, integrally connected, directly connected, or indirectly connected. Those skilled in the art can understand the specific meanings of the above terms in the present disclosure according to specific circumstances.

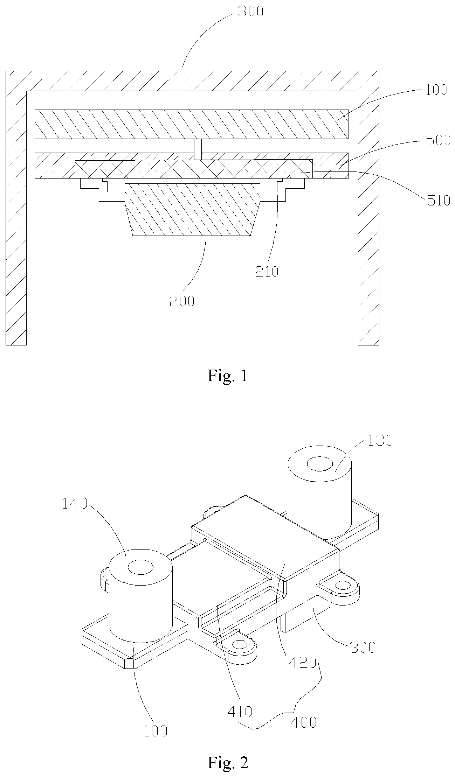

For a better understanding on the present disclosure, a sampling assembly and a battery pack according to the embodiments of the present disclosure will be described in detail below in combination with Fig. 1 to Fig. 6.

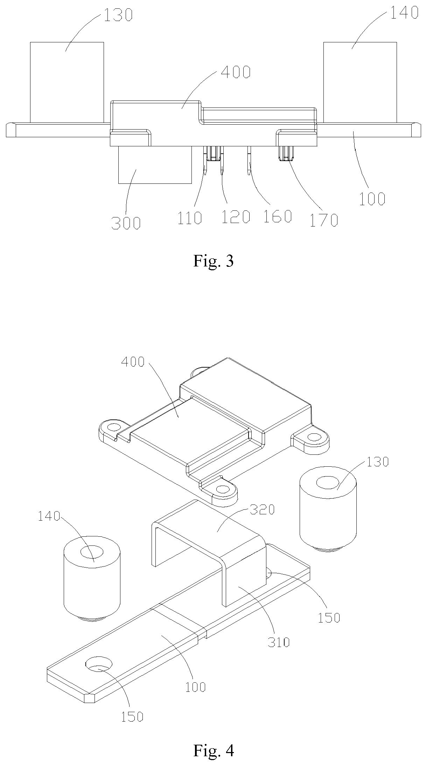

Fig. 1 is a schematic view of a cross-sectional structure of a sampling assembly according to an embodiment of the present disclosure, Fig. 2 is a three-dimensional view of the sampling assembly according to the embodiment of the present disclosure, and Fig. 3 is a side view of Fig. 2. The sampling assembly according to an embodiment of the present disclosure is configured to acquire electrical parameters between two charged terminals to be detected 700. The sampling assembly comprises: a circuit board 500, comprising a sampling unit 510 for receiving sampling signals; a first detector 100, comprising a first connecting end 110 and a second connecting end 120 arranged at interval, wherein the first detector 100 is connected to the circuit board 500 via the first connecting end 110 and the second connecting end 120 to transmit information on first voltage between the first connecting end 110 and the second connecting end 120 to the sampling unit 510, and the first detector 100 is connectable in series to and between the two terminals to be detected 700, so that current flows through the first detector 100 and generates a magnetic field around the first detector 100; and a second detector 200 located in the magnetic field and can generate information on second voltage according to the magnetic field, wherein the second detector 200 comprises an output terminal 210, and the second detector 200 can be connected to the circuit board 500 via the output terminal 210 to transmit the information on second voltage to the sampling unit 510.

The electrical parameters of a sampled object of the sampling assembly are not limited herein, and the electrical parameters may be current information or voltage information between the two terminals to be detected 700, etc. For example, when an input or output cable of a battery pack is sampled using the sampling assembly according to the embodiment of the present disclosure to obtain input or output current of the battery pack, the cable can be cut off to form two terminals to be detected 700, the first detector 100 is bridged between the two terminals to be detected 700 such that the input or output current flows through the first detector 100, and the input or output current is sampled. In addition, voltage information between two terminals to be detected 700 of the battery pack can also be acquired using the sampling assembly according to the embodiment of the present disclosure, which is not redundantly described herein.

The arrangement of the circuit board 500 is not limited herein. When the sampling assembly is used for a battery pack, the circuit board 500 may be a control circuit board of the battery pack, and the first detector 100 and the second detector 200 directly transmit the sampling information to the control circuit board, thereby shortening the transmission distance of the sampling information, and improving the interference resistance of signals. At the same time, the circuit board 500 is not required for the sampling assembly, which greatly simplifies the structure of the sampling assembly.

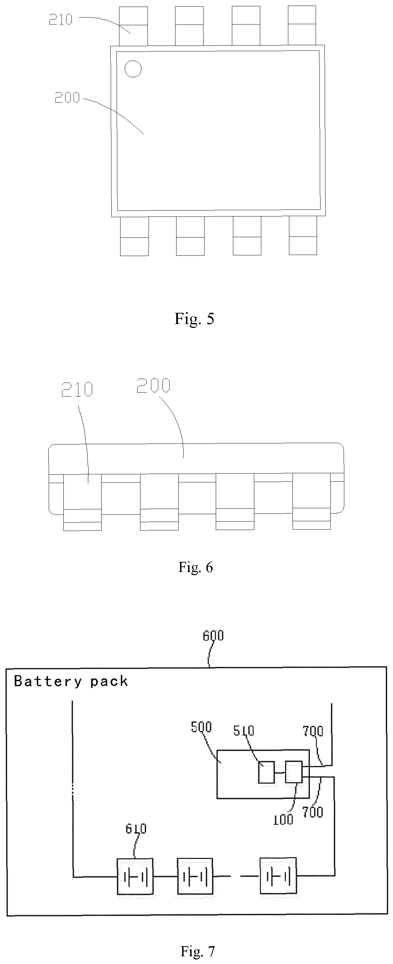

Referring to Fig. 5 and Fig. 6 together, the second detector 200 is arranged in various manners. For example, the second detector 200 is a Hall sensor 200, which generates information on second voltage by using the Hall Effect. The shape of the second detector 200 is not limited herein. Preferably, the second detector 200 is plate-like, so that the second detector 200 can be attached to the circuit board 500 to reduce the space occupied by the second detector 200 and reduce the size of the entire sampling assembly. The number of the output terminal 210 of the second detector 200 is not limited herein. The second detector 200 may have one or more output terminals 210. As shown in Fig. 5 and Fig. 6, the second detector 200 has eight output terminals 210.

The first detector 100 can be arranged in various manners. For example, the first detector 100 is a shunt, and the first detector 100 can be made of a material with good heat resistance, so that the first detector 100 can withstand high temperatures. The first detector 100 is plate-like, so that that the first detector 100 can be attached to the circuit board 500 to reduce the space occupied by the first detector 100 and reduce the size of the entire sampling assembly.

The sampling assembly according to the embodiment of the present disclosure comprises the first detector 100 and the second detector 200, the first detector 100 is connectable in series to and between the two charged terminals to be detected 700 so that current flows through the first detector 100, the first connecting end 110 and the second connecting end 120 are arranged at interval on the first detector 100 so there is a resistance between the first connecting end 110 and the second connecting end 120, there is a pressure difference, i.e., information on first voltage, between the first connecting end 110 and the second connecting end 120 when the current flows between the first connecting end 110 and the second connecting end 120, and the first connecting end 110 and the second connecting end 120 are connected to the circuit board 500 to transmit the information on first voltage to the sampling unit 510. When the sampling assembly is applied to a battery pack and the circuit board 500 is the control circuit board of the battery pack, the control circuit board can transmit the information on first voltage to a battery management system of the battery pack, and the battery management system determines electrical parameters between the two charged terminals to be detected 700 according to the information on first voltage, thereby achieving the purpose of monitoring the electrical parameters between the two terminals to be detected 700.

In addition, when the current flows through the first detector 100, a magnetic field is generated around the first detector 100, and the second detector 200 can generate information on second voltage according to the magnetic field and transmit the information on second voltage to the circuit board 500. When the sampling assembly is applied to the battery pack and the circuit board 500 is the control circuit board of the battery pack, the battery management system in the battery pack acquires the information on second voltage, and determines electrical parameters between the two terminals to be detected 700 according to the information on second voltage.

Therefore, the embodiment of the present disclosure can separately determine the electrical parameters via the first detector 100 and the second detector 200, and the acquisition methods are different, thereby effectively avoiding the common cause failure and improving the reliability of the sampling assembly. Moreover, the first detector 100 and the second detector 200 according to the embodiment of the present disclosure are directly connected to the circuit board 500, which can reduce the transmission distance of the sampling information (i.e., the information on first voltage and the information on second voltage) and enhance the anti-interference ability of signals.

The sampling unit 510 is arranged in various manners. As a preferred embodiment, the sampling unit 510 comprises a first sampling circuit and a second sampling circuit, the first detector 100 is connected to the first sampling circuit via the first connecting end 110 and the second connecting end 120, and the second detector 200 is connected to the second sampling circuit via the output terminal 210.

In these alternative embodiments, the first detector 100 and the second detector 200 transmit information to different sampling circuits of the sampling unit 510 respectively, and the sampling information received by the sampling unit 510 from the first detector 100 and the second detector 200 does not interfere with each other, thereby achieving simultaneous sampling of the first detector 100 and the second detector 200, and improving the accuracy of the sampling results.

It can be understood that the positions of the first detector 100 and the second detector 200 are not limited herein as long as the second detector 200 can be located in the magnetic field generated around the first detector 100 and can generate information on second voltage according to the magnetic field.

In some alternative embodiments, the first detector 100 and the second detector 200 are arranged on two sides of the circuit board 500. In these alternative embodiments, the first detector 100 and the second detector 200 are arranged on the two sides of the circuit board 500, so that both the first detector 100 and the second detector 200 can be directly connected to the circuit board 500 to reduce the transmission distance of the sampling information. The first detector 100 and the second detector 200 are arranged on the two sides of the circuit board 500, which means that the first detector 100 and the second detector 200 are arranged on the two sides of the circuit board 500 in the thickness direction of the circuit board 500, that is, the first detector 100 and the second detector 200 are arranged on the two sides of the circuit board 500 in the vertical direction shown in Fig. 1.

Further preferably, the first detector 100 and the second detector 200 are correspondingly arranged in the thickness direction of the circuit board 500 such that only one circuit board 500 is arranged between the first detector 100 and the second detector 200, the distance between the first detector 100 and the second detector 200 is short, and the strength of the magnetic field where the second detector 200 is located is relatively strong, which ensures the reliability of the second detector 200 and can also reduce the space occupied by the sampling assembly. The thickness direction of the circuit board 500 may be the vertical direction in Fig. 1.

Referring to Fig. 4, which is a schematic view of an exploded structure of Fig. 2, in some alternative embodiments, the sampling assembly further comprises a magnetic gathering sheet 300 arranged on a circumferential side of the second detector 200 to gather the magnetic field. In these alternative embodiments, the magnetic gathering sheet 300 is located on the circumferential side of the second detector 200, and can gather the magnetic field on the circumferential side of the second detector 200, thereby enhancing the strength of the magnetic field, ensuring the operational reliability of the second detector 200, and improving the performance of the second detector 200. The material of the magnetic gathering sheet 300 is not limited herein. In order to improve the magnetic gathering effect, the magnetic gathering sheet 300 is made of a soft magnetic material with high magnetic conductivity.

It can be understood that the magnetic gathering sheet 300 is arranged in various manners. In some alternative embodiments, the magnetic gathering sheet 300 is of U-shape, has two opposite side walls 310 and a bottom wall 320 connecting the two side walls 310, and spans the two sides of the second detector 200 and the first detector 100 via the side walls 310. In these alternative embodiments, the magnetic gathering sheet 300 is of U-shape and spans the two sides of the second detector 200 and the first detector 100 via the two side walls 310 to achieve a higher magnetic gathering effect.

In some alternative embodiments, the two side walls 310 of the magnetic gathering sheet 300 span the two sides of the second detector 200 in the width direction, and the first detector 100 and the second detector 200 are both located on the two side walls 310. The relative positions of the first detector 100 and the second detector 200 are not limited herein. The first detector 100 is located on a side close to the bottom wall 320, and at this time, the first detector 100 is located between the bottom wall 320 and the circuit board 500; or, the second detector 200 is located on a side close to the bottom wall 320, and at this time, the second detector 200 is located between the circuit board 500 and the bottom wall 320.

In some alternative embodiments, the sampling assembly further comprises a fixing seat 400 for fixing the magnetic gathering sheet 300 and the first detector 100 to the circuit board 500 to ensure the stability of the relative positions of the first detector 100 and the magnetic gathering sheet 300, so that the magnetic field where the magnetic gathering sheet 300 is located is more stable, the stability of the magnetic field is ensured, and the operation of the second detector 200 is also more stable.

The specific arrangement of the fixing seat 400 is not limited herein. In some alternative embodiments, the fixing seat 400 comprises a first groove 410 and a second groove 420 distributed successively, the first groove 410 matches the first detector 100 in shape, and the second groove 420 matches the magnetic gathering sheet 300 in shape, so that the fixing seat 400 can be sleeved on the magnetic gathering sheet 300 and the first detector 100 via the first groove 410 and the second groove 420, and fixes the first detector 100 and the magnetic gathering sheet 300 to the circuit board 500.

In these alternative embodiments, since the first groove 410 matches the first detector 100 in shape, the first detector 100 can be caught in the first groove 410, and similarly, the bottom wall 320 of the magnetic gathering sheet 300 and part of the side walls 310 connected to the bottom wall 320 can be caught in the second groove 420. When the fixing seat 400 is sleeved on the magnetic gathering sheet 300 and the first detector 100 and fixes the first detector 100 to the circuit board 500, the stability of the relative positions of the first detector 100, the magnetic gathering sheet 300 and the circuit board 500 is ensured.

The material of the fixing seat 400 is not limited herein. To ensure the safety, the fixing seat 400 is made of an insulating material.

In some alternative embodiments, the first detector 100 further comprises a first input end 130 and a first output end 140, so that the first detector 100 is connectable in series to and between the two terminals to be detected 700 via the first input end 130 and the first output end 140. The connection between the terminals to be detected 700 and the first detector 100 is facilitated by providing the first input end 130 and the first output end 140.

As shown in Fig. 2 to Fig. 4, the first input end 130 is arranged on a side close to the magnetic gathering sheet 300, and the first output end 140 is arranged on a side away from the magnetic gathering sheet 300, but the positions of the first input end 130 and the first output end 140 are not limited thereto, for example, the first output end 140 is arranged on a side close to the magnetic gathering sheet 300, and the first input end 130 is arranged on a side away from the magnetic gathering sheet 300.

It can be understood that the first input end 130 and the first output end 140 are arranged in various manners, for example, the first input end 130 is columnar, a threaded hole is provided in the axial direction of the columnar first input end 130 so that one terminal to be detected 700 can be connected to the first input end 130 via the threaded hole, and the first detector 100 is provided with a connecting hole 150 such that the first input end 130 can be connected to the first detector 100 via the connecting hole 150.

The material of the first input end 130 is not limited herein. To ensure a good electrical connection between the terminal to be detected 700 and the first detector 100, the first input end 130 is made of a conductive material, and preferably, the first input end 130 is a copper cylinder with a threaded hole.

The first input end 130 is connected to the first detector 100 via the connecting hole 150 in various manners, for example, the first input end 130 is welded to the first detector 100 via the connecting hole 150, or the first input end 130 is riveted to the first detector 100 via the connecting hole 150.

The arrangement methods of the first output end 140 and the first input end 130 may be the same or different, preferably, the same, to simplify the processing flow and assembly.

In any of the above embodiments, the shape of the first detector 100 is not limited herein. To simplify the device structure, the first detector 100 is plate-like, and extends a preset length in the horizontal direction as shown in Fig. 3. The first detector 100 has opposite top and bottom surfaces, the first input end 130 and the first output end 140 are arranged on the top surface, and the first connecting end 110 and the second connecting end 120 are arranged on the bottom surface.

In these alternative embodiments, the first input end 130, the first output end 140, the first connecting end 110 and the second connecting end 120 are located on different surfaces of the first detector 100 so that no interference occurs therebetween. When the bottom surface of the first detector 100 is arranged close to the circuit board 500, the transmission distance between the first detector 100 and the circuit board 500 can be further reduced.

It can be understood that the arrangement of the first detector 100 is not limited thereto. As shown in Fig. 3, the surface of the first detector is further provided with a third connecting end 160, which is used for grounding to improve the safety performance of the first detector 100.

The first connecting end 110, the second connecting end 120 and the third connecting end 160 may be fixed to the surface of the first detector 100 by bonding, welding or the like.

The connection manner of the first detector 100 and the circuit board is not limited herein, and the first detector may be fixed to the circuit board by bonding or welding. In some alternative embodiments, the sampling assembly further comprises a limiting post 170, and the first detector 100 is connected to the circuit board 500 via the limiting post 170. Further preferably, the circuit board 500 is provided with a mounting hole (not shown) corresponding to the limiting post 170, so that the limiting post 170 can be located in the mounting hole, and the first detector 100 is mounted to the circuit board 500 via the cooperation of the limiting post 170 and the mounting hole.

The first connecting end 110 and the second connecting end 120 are arranged in various manners. In some alternative embodiments, the first connecting end 110 and the second connecting end 120 are both needle-like and perpendicular to the bottom surface. The first connecting end 110 and the second connecting end 120 are made of a material with high conductivity, so that the resistance between the first connecting end 110 and the second connecting end 120 is small. The current information between the first connecting end 110 and the second connecting end 120 can be calculated by acquiring the information on first voltage between the first connecting end 110 and the second connecting end 120 according to the Ohm's law.

Referring to Fig. 7, a second embodiment of the present disclosure further provides a battery pack, comprising a case 600 in which one or more battery modules 610 are arranged, two terminals to be detected 700 and the sampling assembly according to any of the first embodiments, wherein the first detector 100 of the sampling assembly is connected in series to and between the two terminals to be detected 700, and the circuit board 500 is located inside or outside the case 600.

The two terminals to be detected 700 can be arranged at an input circuit or output circuit of the battery pack, so that the sampling assembly can be connected in series to the input circuit or output circuit of the battery pack, and can collect the input or output current of the battery pack.

The circuit board 500 may be arranged inside the case 600. When the circuit board 500 is arranged inside the case 600, the circuit board 500 may be arranged separately, or the circuit board 500 is a control circuit board of the battery pack, which facilitates a battery management system in the battery pack. To acquire the information on first voltage and the information on second voltage, thereby achieving the purpose of monitoring electrical parameters between the two terminals to be detected 700.

The embodiment of the present disclosure comprises the sampling assembly according to any of the above embodiments, and thus has the beneficial effects of any of the above sampling assemblies, which is not redundantly described herein.

The present disclosure may be embodied in other specific forms without departing from the principle and essential characteristics. For example, the algorithms described in the specific embodiments may be modified, while the system architecture does not depart from the basic principle of the present disclosure. Therefore, the present embodiments are considered in all respects as illustrative and nondeterministic, the scope of the present disclosure is defined by the appending claims instead of the above descriptions, and all changes falling within the scope of the meanings of the claims and the equivalents are included within the scope of the present disclosure.

## Claims

1. A sampling assembly for acquiring electrical parameters between two charged terminals to be detected (700), comprising:
a circuit board (500), comprising a sampling unit (510) for receiving sampling signals;
a first detector (100), comprising a first connecting end (110) and a second connecting end (120) arranged at interval, wherein the first detector (100) is connected to the circuit board (500) via the first connecting end (110) and the second connecting end (120) to transmit information on first voltage between the first connecting end (110) and the second connecting end (120) to the circuit board (500), and the first detector (100) is connectable in series to and between the two terminals to be detected (700), so that current flows through the first detector (100) and generates a magnetic field around the first detector (100); and
a second detector (200), located in the magnetic field and can generate information on second voltage according to the magnetic field, wherein the second detector (200) comprises an output terminal (210), and the second detector (200) is connectable to the circuit board (500) via the output terminal (210) to transmit the information on second voltage to the sampling unit (510).

2. The sampling assembly according to claim 1, **characterized in that** the first detector (100) and the second detector (200) are arranged on two sides of the circuit board (500), and are correspondingly arranged in a thickness direction of the circuit board (500).

3. The sampling assembly according to claim 1, **characterized in** further comprising a magnetic gathering sheet (300) arranged around the second detector (200) to gather the magnetic field.

4. The sampling assembly according to claim 3, **characterized in that** the magnetic gathering sheet (300) is of U-shape, has two opposite side walls (310) and a bottom wall (320) connecting the two side walls (310), and spans the two sides of the second detector (200) and the first detector (100) via the side walls (310).

5. The sampling assembly according to claim 4, **characterized in that** the first detector (100) is arranged between the bottom wall (320) and the circuit board (500), or the second detector (200) is arranged between the bottom wall (320) and the circuit board (500).

6. The sampling assembly according to claim 4, **characterized in** further comprising a fixing seat (400) to fix the magnetic gathering sheet (300) and the first detector (100) to the circuit board (500).

7. The sampling assembly according to claim 6, **characterized in that** the fixing seat (400) comprises a first groove (410) and a second groove (420) distributed successively, the first groove (410) matches the first detector (100) in shape, and the second groove (420) matches the magnetic gathering sheet (300) in shape, so that the fixing seat (400) can be sleeved on the magnetic gathering sheet (300) and the first detector (100) via the first groove (410) and the second groove (420), and fixes the first detector (100) and the magnetic gathering sheet (300) to the circuit board (500).

8. The sampling assembly according to claim 1, **characterized in that** the first detector (100) further comprises a first input end (130) and a first output end (140), so that the first detector (100) is connectable in series to and between the two terminals to be detected (700) via the first input end (130) and the first output end (140).

9. The sampling assembly according to claim 8, **characterized in that**
the first input end (130) is columnar and is axially provided with a threaded hole so that one terminal to be detected (700) is connected to the first input end (130) via the threaded hole, and the first detector (100) is provided with a connecting hole (150) so that the first input end (130) is connected to the first detector (100) via the connecting hole (150);
and/or, the first output end (140) is columnar and is axially provided with a threaded hole so that one terminal to be detected (700) is connected to the first output end (140) via the threaded hole, and the first detector (100) is provided with a connecting hole (150) so that the first output end (140) is connected to the first detector (100) via the connecting hole (150).

10. The sampling assembly according to claim 8, **characterized in that** the first detector (100) has a top surface and a bottom surface opposite to each other, the first input end (130) and the first output end (140) are arranged on the top surface, and the first connecting end (110) and the second connecting end (120) are arranged on the bottom surface.

11. The sampling assembly according to claim 1, **characterized in that** the sampling unit (510) comprises a first sampling circuit and a second sampling circuit, the first detector (100) is connected to the first sampling circuit via the first connecting end (110) and the second connecting end (120), and the second detector (200) is connected to the second sampling circuit via the output terminal (210).

12. A battery pack, **characterized in** comprising:
a case (600) in which more than one battery module (610) is arranged;
two charged terminals to be detected (700);
the sampling assembly according to any one of claims 1-11, wherein the first detector (100) of the sampling assembly is connected in series to and between the two terminals to be detected (700), and the circuit board (500) of the sampling assembly is located inside or outside the case (600).
